# EUROPEAN PATENT APPLICATION

(11) **EP 4 769 940 A1**
(43) Date of publication of application: **01.07.2026**
(21) Application number: 24857828.8
(22) Date of filing: 07.05.2024
(51) Int. Cl.: H02S 40/34, H05K 5/02, H05K 5/03, H05K 7/20

(54) **PHOTOVOLTAIC OPTIMIZER**

(30) Priority: 25.08.2023 CN 202322308881 U
(71) Applicant: Huawei Digital Power Technologies Co., Ltd., Shenzhen, Guangdong 518043 (CN)
(72) Inventor: WU, Baoshan, Shenzhen, Guangdong 518043 (CN); DENG, Guoliang, Shenzhen, Guangdong 518043 (CN); YIN, Wenle, Shenzhen, Guangdong 518043 (CN); SONG, Niancong, Shenzhen, Guangdong 518043 (CN)
(74) Representative: Maiwald GmbH
(86) International application number: PCT/CN2024/091469
(87) International publication number: WO 2025/044279

(57) **Abstract**

This application provides a photovoltaic optimizer. The photovoltaic optimizer includes a cover, a heat dissipation panel, a mainboard, and an insulation supporting member. The cover is fastened to the heat dissipation panel, and an accommodation cavity is formed between the cover and the heat dissipation panel. The mainboard is located in the accommodation cavity. The insulation supporting member is mounted between the mainboard and the heat dissipation panel. The insulation supporting member is configured to support the mainboard. At least one ring-shaped boss or at least one ring-shaped groove is provided on a side surface of the insulation supporting member along a first direction. The first direction is perpendicular to a plane on which the mainboard is located. In the photovoltaic optimizer in embodiments of this application, the ring-shaped boss or the ring-shaped groove is provided on the side surface of the insulation supporting member in a creepage path, to increase a creepage distance. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

## Description

This application claims priority to Chinese Patent Application No. 202322308881.0, filed with the China National Intellectual Property Administration on August 25, 2023, and entitled "Photovoltaic Optimizer", which is incorporated herein by reference in its entirety.

### TECHNICAL FIELD

Embodiments of this application relate to the field of photovoltaic technologies, and more specifically, to a photovoltaic optimizer.

### BACKGROUND

A housing of a photovoltaic optimizer product may be touched by a human hand and is usually not grounded. Therefore, the housing and an internal circuit need to meet reinforced insulation. In addition, a high-voltage region is included in a power supply. A safety regulation requires that the high-voltage region and a metal housing meet reinforced insulation to ensure personal safety.

A photovoltaic optimizer is usually filled with potting adhesive, to enhance insulation effect and avoid a discharge phenomenon between a mainboard and a heat dissipation panel and a discharge phenomenon between a cable terminal and a metal housing of the photovoltaic optimizer. Therefore, an electric clearance and a creepage distance between the mainboard and the heat dissipation panel need to meet a specific limit value, and an electric clearance and a creepage distance between the cable terminal and the metal housing of the photovoltaic optimizer need to meet a specific limit value. This means that internal space of the photovoltaic optimizer needs to be compromised to meet the foregoing requirements. This leads to an increase in costs and an amount of potting adhesive used.

### SUMMARY

This application provides a photovoltaic optimizer, to reduce an overall size of the photovoltaic optimizer, an amount of potting adhesive used in the photovoltaic optimizer, and costs when a creepage distance limit is met.

According to a first aspect, a photovoltaic optimizer is provided. The photovoltaic optimizer includes a cover, a heat dissipation panel, a mainboard, and an insulation supporting member. The cover is fastened to the heat dissipation panel, and an accommodation cavity is formed between the cover and the heat dissipation panel. The mainboard is located in the accommodation cavity. The insulation supporting member is mounted between the mainboard and the heat dissipation panel. The insulation supporting member is configured to support the mainboard. At least one ring-shaped boss or at least one ring-shaped groove is provided on a side surface of the insulation supporting member along a first direction. The first direction is perpendicular to a plane on which the mainboard is located.

In the photovoltaic optimizer provided in this application, the at least one ring-shaped boss or the at least one ring-shaped groove is provided on the insulation supporting member in a creepage path, to increase a creepage distance, and avoid a risk of a discharge phenomenon between the mainboard and the heat dissipation panel. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

It should be understood that the creepage distance is a shortest path, measured along an insulated surface, between two conducting components or between a conducting component and a protection interface of a device. In this embodiment, the accommodation cavity is filled with insulation potting adhesive, and a creepage distance between the mainboard and the heat dissipation panel may be a distance along a surface of the insulation supporting member. Therefore, a size of the boss or the groove on the insulation supporting member may be set to increase the creepage distance.

In a possible implementation, when the at least one ring-shaped groove is provided on the side surface of the insulation supporting member along the first direction, a distance of the ring-shaped groove along the first direction is greater than a specific limit value, so that the potting adhesive can flow into the ring-shaped groove on the insulation supporting member.

With reference to the first aspect, in some implementations of the first aspect, the photovoltaic optimizer further includes a cable, the cable includes a cable terminal and a cable insulation sheath, the cable terminal is connected to the mainboard, at least one ring-shaped boss is provided on the cable insulation sheath along a second direction, the at least one ring-shaped boss on the cable insulation sheath is located in the accommodation cavity formed between the cover and the heat dissipation panel, and the second direction points to an extension direction of the cable.

In the photovoltaic optimizer provided in this application, the ring-shaped boss is provided on an outer surface of the cable insulation sheath in a creepage path, to increase a creepage distance, and avoid a risk of discharging between the cable terminal and a metal housing (for example, the heat dissipation panel) of the photovoltaic optimizer. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

In a possible implementation, a projection of a body part of the insulation supporting member on the mainboard falls within a range of a projection of the ring-shaped boss of the insulation supporting member on the mainboard; or a projection of the ring-shaped groove of the insulation supporting member on the mainboard falls within a range of a projection of a body part of the insulation supporting member on the mainboard. To be specific, the insulation supporting member may include the body part and a convex part that protrudes outward along a side surface of the body part, and the projection of the body part on the mainboard falls within a range of a projection of the convex part on the mainboard; or the insulation supporting member may include the body part and a recessed part that is recessed inward along a side surface of the body part, and a projection of the recessed part on the mainboard falls within a range of the projection of the body part on the mainboard.

In a possible implementation, at least one fastener is provided at an end, close to the mainboard, of the insulation supporting member, a fastener hole is provided at a position, on the mainboard, that corresponds to the fastener, and the fastener passes through the fastener hole to fasten the insulation supporting member and the mainboard. Correspondingly, the insulation supporting member may be fastened to the mainboard through the fastener, to clamp the mainboard.

With reference to the first aspect, in some implementations of the first aspect, the insulation supporting member is an insulation supporting post; and the insulation supporting post includes a body part and a convex part that protrudes outward along a side wall of the body part, and a projection of the body part along the first direction falls within a range of a projection of the convex part along the first direction; or the insulation supporting post includes a body part and a recessed part that is recessed inward along a side wall of the body part, and a projection of the recessed part along the first direction falls within a range of a projection of the body part along the first direction.

In the photovoltaic optimizer provided in this application, the insulation supporting member may be the insulation supporting post, and the insulation supporting post performs a function of supporting the mainboard, so that an overall structure of the photovoltaic optimizer is more stable, and the photovoltaic optimizer is prevented from shaking during transportation.

In a possible implementation, a clamping post is provided at an end, close to the mainboard, of the insulation supporting post, a projection of the clamping post along the first direction falls within the range of the projection of the body part along the first direction, a clamping post hole is provided at a position, on the mainboard, that corresponds to the clamping post, and the clamping post passes through the clamping post hole to fasten the insulation supporting post and the mainboard. Correspondingly, the insulation supporting post may be fastened to the mainboard through the clamping post, to clamp the mainboard. For example, the clamping post may be connected to an end face, close to the mainboard, of the body part of the insulation supporting post, a clamping post hole is provided on the mainboard, and the clamping post may pass through the clamping post hole to fasten the insulation supporting post and the mainboard.

In a possible implementation, at least one fastener is provided at an end, close to the mainboard, of the insulation supporting post, a fastener hole is provided at a position, on the mainboard, that corresponds to the fastener, and the fastener passes through the fastener hole to fasten the insulation supporting post and the mainboard. Correspondingly, the insulation supporting post may be fastened to the mainboard through the fastener, to clamp the mainboard. For example, the fastener may be connected to an end face, close to the mainboard, of the body part of the insulation supporting post, a fastener hole is provided on the mainboard, and the fastener may pass through the fastener hole to fasten the insulation supporting post and the mainboard.

In a possible implementation, adhesive is applied to an end, close to the mainboard, of the insulation supporting post. To be specific, the insulation supporting post may be bonded to the mainboard, to fasten the insulation supporting post to the mainboard.

With reference to the first aspect, in some implementations of the first aspect, the photovoltaic optimizer further includes a screw, a first through hole is provided on the mainboard, a second through hole is provided on the insulation supporting member along the first direction, a threaded hole corresponding to the screw is provided on the heat dissipation panel, the threaded hole, the first through hole, and the second through hole overlap on a projection plane along the first direction, and the screw passes through the first through hole and the second through hole and is fastened to the threaded hole. To be specific, the insulation supporting member may have a hollow structure, the screw can pass through the insulation supporting member, the screw can perform a function of fastening the mainboard and the heat dissipation panel, and the insulation supporting member can perform a function of supporting the mainboard. Therefore, the structure can implement a hard connection between the mainboard and the heat dissipation panel and also perform a support function. In this way, an overall structure is more stable, and the photovoltaic optimizer is prevented from shaking during transportation.

In a possible implementation, the photovoltaic optimizer further includes an insulation screw sleeve, the screw includes a screw head and a screw rod, a part of the insulation screw sleeve is located between the mainboard and the screw head, a part of the insulation screw sleeve passes through the first through hole and extends into the second through hole, and the screw rod passes through a part, passing through the second through hole, of the insulation screw sleeve, and is fastened to the threaded hole. To be specific, the insulation screw sleeve is provided between the screw and the mainboard to isolate the screw from the mainboard, and the insulation screw sleeve (for example, a screw sleeve made of a plastic material) can perform a function of isolating the screw from the mainboard.

In a possible implementation, the insulation supporting member is at a midpoint position on each of four sides of the mainboard.

It should be noted that a position for disposing the insulation supporting member may be determined based on an actual layout of components on the mainboard. In an example, the insulation supporting member may be disposed at a middle position on a side, close to the cable, of the mainboard. In an example, the insulation supporting member may be disposed at a middle position on a side, away from the cable, of the mainboard.

In a possible implementation, the photovoltaic optimizer further includes an aluminum substrate, the aluminum substrate is located between the mainboard and the heat dissipation panel and is fastened to the mainboard, and a power device is mounted on the aluminum substrate.

In this implementation, the aluminum substrate is disposed between the mainboard and the heat dissipation panel, and a power device (for example, a MOS transistor or a diode) that generates a large amount of heat may be mounted on the aluminum substrate. This can reduce a quantity of power devices on the mainboard, and can also increase a heat transfer path for the power device, to accelerate heat dissipation.

According to a second aspect, a photovoltaic optimizer is provided. The photovoltaic optimizer includes a cover, a heat dissipation panel, a mainboard, a screw, and an insulation screw sleeve. The cover is fastened to the heat dissipation panel, and an accommodation cavity is formed between the cover and the heat dissipation panel. The mainboard is located in the accommodation cavity. A first through hole is provided on the mainboard. A threaded hole corresponding to the screw is provided on the heat dissipation panel. The threaded hole and the first through hole overlap on a projection plane along a first direction. The first direction is perpendicular to a plane on which the mainboard is located. The screw includes a screw head and a screw rod. A part of the insulation screw sleeve is located between the mainboard and the screw head. A part of the insulation screw sleeve passes through the first through hole and extends toward the heat dissipation panel. The screw rod passes through a part, passing through the second through hole, of the insulation screw sleeve, and is fastened to the threaded hole. At least one ring-shaped boss or at least one ring-shaped groove is provided, along the first direction, on a part, passing through the first through hole, of the insulation screw sleeve.

In the photovoltaic optimizer provided in this application, the at least one ring-shaped boss or the at least one ring-shaped groove is provided on the insulation screw sleeve in a creepage path, to increase a creepage distance, and avoid a risk of a discharge phenomenon between the mainboard and the heat dissipation panel. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

In a possible implementation, when the at least one ring-shaped groove is provided on a side surface of the insulation screw sleeve along the first direction, a distance of the ring-shaped groove along the first direction is greater than a specific limit value, so that potting adhesive can flow into the ring-shaped groove on the insulation screw sleeve.

With reference to the second aspect, in some implementations of the second aspect, the photovoltaic optimizer further includes a cable, the cable includes a cable terminal and a cable insulation sheath, the cable terminal is connected to the mainboard, at least one ring-shaped boss is provided on the cable insulation sheath along a second direction, the at least one ring-shaped boss on the cable insulation sheath is located in the accommodation cavity formed between the cover and the heat dissipation panel, and the second direction points to an extension direction of the cable.

In the photovoltaic optimizer provided in this application, the ring-shaped boss is provided on an outer surface of the cable insulation sheath in a creepage path, to increase a creepage distance, and avoid a risk of discharging between the cable terminal and a metal housing (for example, the heat dissipation panel) of the photovoltaic optimizer. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

With reference to the second aspect, in some implementations of the second aspect, the photovoltaic optimizer further includes an aluminum substrate, the aluminum substrate is located between the mainboard and the heat dissipation panel and is fastened to the mainboard, and a power device is mounted on the aluminum substrate.

In this implementation, the aluminum substrate is disposed between the mainboard and the heat dissipation panel, and a power device (for example, a MOS transistor or a diode) that generates a large amount of heat may be mounted on the aluminum substrate. This can reduce a quantity of power devices on the mainboard, and can also increase a heat transfer path for the power device, to accelerate heat dissipation.

### BRIEF DESCRIPTION OF DRAWINGS

FIG. 1 is a three-dimensional diagram of a structure of a photovoltaic optimizer;
FIG. 2 is an exploded view of a structure of the photovoltaic optimizer shown in FIG. 1;
FIG. 3 is a schematic cross-sectional view of a connection part between a mainboard and a heat dissipation panel in FIG. 1;
FIG. 4 is a schematic cross-sectional view of a connection part between a cable and a mainboard in FIG. 1;
FIG. 5 is a diagram of a partial structure of a photovoltaic optimizer according to an embodiment of this application;
FIG. 6 is a side view of a structure of a photovoltaic optimizer according to an embodiment of this application;
FIG. 7 is a three-dimensional diagram of a structure of an insulation supporting member according to an embodiment of this application;
FIG. 8 is a three-dimensional diagram of a structure of another insulation supporting member according to an embodiment of this application;
FIG. 9 is a schematic cross-sectional view of another insulation supporting member according to an embodiment of this application;
FIG. 10 is a schematic cross-sectional view of another insulation supporting member according to an embodiment of this application;
FIG. 11 is a schematic cross-sectional view of an insulation screw sleeve according to an embodiment of this application; and
FIG. 12 is a schematic cross-sectional view of a cable insulation sheath according to an embodiment of this application.

### DESCRIPTION OF EMBODIMENTS

The following describes technical solutions of this application with reference to accompanying drawings.

For ease of understanding of embodiments of this application, the following descriptions are provided before embodiments of this application are described.

In descriptions of embodiments of this application, "/" indicates "or", unless otherwise specified. For example, A/B may indicate A or B. The term "and/or" in this specification describes only an association relationship between associated objects, and indicates that three relationships may exist. For example, A and/or B may indicate the following three cases: Only A exists, both A and B exist, and only B exists.

The terms "first" and "second" in embodiments of this application are merely intended for a purpose of description, and shall not be understood as an indication or an implication of relative importance or an implicit indication of a quantity of indicated technical features. Therefore, a feature limited by "first" or "second" may explicitly or implicitly include one or more features. In addition, in descriptions of embodiments of this application, "a plurality of" means two or more, and "at least one" and "one or more" mean one, two, or more. The singular expressions "one", "a", "the", "the foregoing", "this", and "the one" are also intended to include an expression such as "one or more", unless the opposite is explicitly indicated in the context thereof. Sequence numbers of the following processes do not mean execution sequences. Execution sequences of the processes should be determined based on functions and internal logic of the processes, and should not be construed as any limitation on implementation processes of embodiments of this application. For example, in embodiments of this application, the terms "110", "120", "130", and the like are merely identifiers for ease of description, and are not intended to limit an execution sequence of steps.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

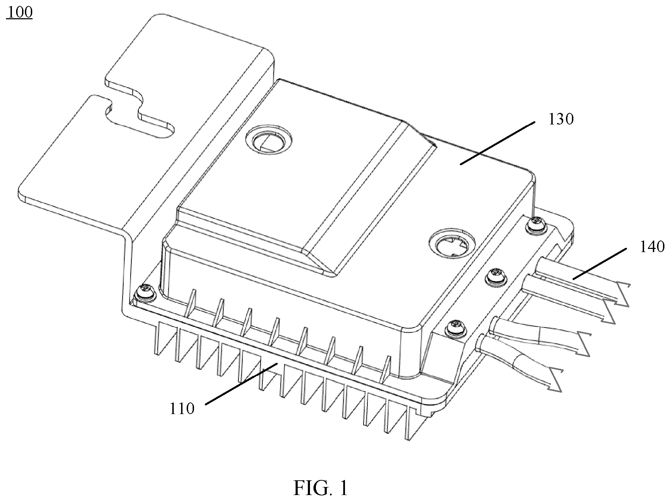

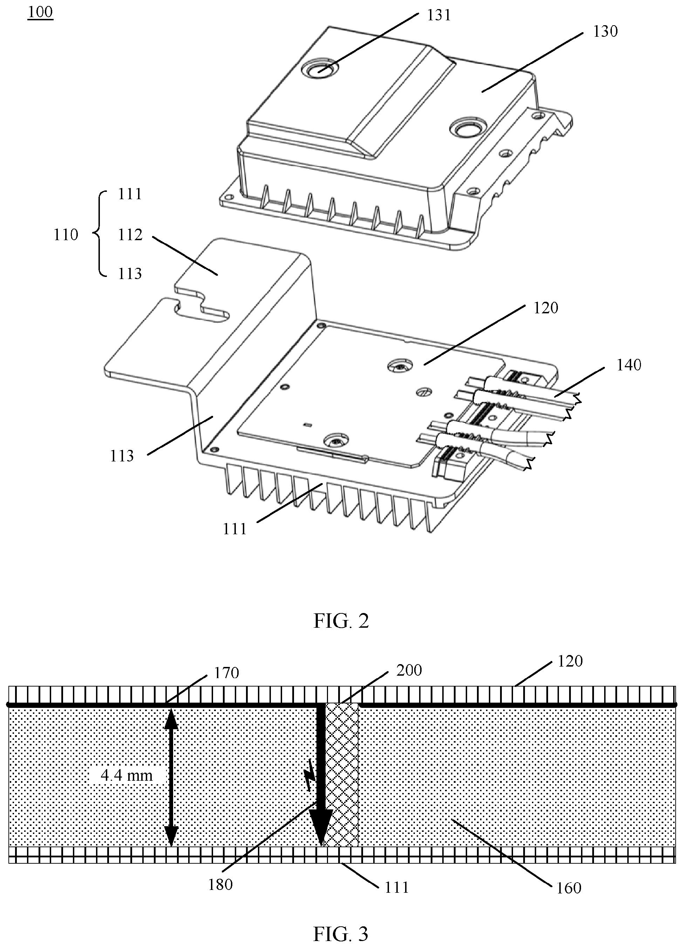

FIG. 1 is a three-dimensional diagram of a structure of a photovoltaic optimizer. FIG. 2 is an exploded view of a structure of the photovoltaic optimizer shown in FIG. 1.

With reference to FIG. 1 and FIG. 2, it can be learned that the photovoltaic optimizer 100 includes a housing 110, a mainboard 120, a cover 130, and a cable 140. The cover 130 is configured to cover the housing 110 to form an accommodation cavity. The accommodation cavity is used to accommodate the mainboard 120. A whole formed by covering the housing 110 by the cover 130 includes at least one through hole. An electronic component may be mounted on the mainboard 120. An input end of the cable 140 may be connected to the mainboard 120 through the at least one through hole.

It should be understood that, in FIG. 1, that the whole formed by covering the housing 110 by the cover 130 includes four through holes, and positions of the through holes are merely examples. A quantity and positions of through holes may be set according to an actual use requirement.

As shown in FIG. 2, the housing 110 includes a heat dissipation panel 111, a mounting ear 112, and a connecting plate 113. The heat dissipation panel 111, the mounting ear 112, and the connecting plate 113 form a Z-shaped structure. The connecting plate 113 is connected between the heat dissipation panel 111 and the mounting ear 112. The mounting ear 112 and the heat dissipation panel 111 are respectively located at two opposite ends of the connecting plate 113, so that the heat dissipation panel 111 and the mounting ear 112 are not located on a same plane. The heat dissipation panel 111 is fastened to the mainboard 120, and may dissipate heat for at least one electronic component on the mainboard 120.

It should be understood that the heat dissipation panel 111 may be fastened to the mainboard 120 by using a screw, through clamping, or in another manner, to improve stability of the photovoltaic optimizer and improve safety.

A fin-shaped heat dissipation structure, for example, heat dissipation fins, is disposed on a surface, away from the mainboard 120, of the heat dissipation panel 111. As shown in FIG. 2, one side, used for fastening the mainboard 120, of the heat dissipation panel 111 is a plane, and the other side of the heat dissipation panel 111 is in a fin shape. The fin-shaped heat dissipation structure is used, so that a heat dissipation area can be increased, and heat dissipation efficiency can be improved. A material of the heat dissipation panel 111 may be a metal or an alloy with a high thermal conductivity, for example, copper or aluminum.

The mounting ear 112 is configured to mount the photovoltaic optimizer 100 on a photovoltaic module. The mounting ear 112 includes a mounting hole. During mounting, the photovoltaic optimizer 100 is fastened to an extruded frame of the photovoltaic module by using a fastener or a screw through the mounting hole.

The cover 130 is configured to cover the housing 110 to form the accommodation cavity. Specifically, the cover 130 is fastened to the heat dissipation panel 111, and the accommodation cavity is formed between the cover 130 and the heat dissipation panel 111. The mainboard 120 may be located in the accommodation cavity. In one example, the cover 130 includes an injection hole 131, and the injection hole 131 may be used to inject potting filler into the accommodation cavity. To be specific, the photovoltaic optimizer 100 may be filled with potting adhesive, and the potting adhesive is used for insulation and heat dissipation.

The cable 140 may pass through the at least one through hole formed by covering the heat dissipation panel 111 by the cover 130, to be connected to the mainboard 120. Specifically, as shown in FIG. 2, a first part of the cable 140 is located in the accommodation cavity, the first part of the cable 140 includes a cable terminal 141 and a cable insulation sheath 142, and the cable terminal 141 is connected to the mainboard 120. A second part of the cable 140 may be located outside the accommodation cavity, and is connected to a photovoltaic panel. It should be understood that a manner of connecting the cable 140 to the mainboard 120 is not limited. In an example, the cable 140 is electrically connected to the mainboard 120 through welding. In another example, a connector is provided on the mainboard 120, and the cable 140 may be directly inserted into the connector to be electrically connected to the mainboard 120.

In some embodiments, as shown in FIG. 2, the photovoltaic optimizer 100 may further include an aluminum substrate 121, the aluminum substrate 121 is located between the mainboard 120 and the heat dissipation panel 111 and is fastened to the mainboard 120, and a power device is mounted on the aluminum substrate 121. The power device may be a power device that generates a large amount of heat, for example, a metal-oxide semiconductor field-effect transistor (Metal-Oxide-Semiconductor Field-Effect Transistor, MOSFET), MOS transistor for short, or a diode. It should be understood that some power devices that generate a large amount of heat are disposed on the aluminum substrate 121, so that a quantity of power devices on the mainboard 120 can be reduced, and a heat transfer path for the power device can also be reduced, to accelerate heat dissipation.

As described in the background, a metal housing (including the housing 110 and the cover 130) of the photovoltaic optimizer 100 may be touched by a human hand and is usually not grounded. Therefore, the metal housing and an internal circuit need to meet reinforced insulation. In addition, a high-voltage region is included in a power supply. A safety regulation requires that the high-voltage region and the metal housing or the heat dissipation panel meet reinforced insulation to ensure personal safety.

Currently, the photovoltaic optimizer 100 is usually filled with potting adhesive, to enhance insulation effect and avoid a discharge phenomenon between the mainboard 120 and the heat dissipation panel 111 and a discharge phenomenon between the cable terminal 141 and the metal housing (for example, the heat dissipation panel 111 or the cover 130) of the photovoltaic optimizer 100. Therefore, an electric clearance and a creepage distance between the mainboard 120 and the heat dissipation panel 111 need to meet a specific limit value, and an electric clearance and a creepage distance between the cable terminal 141 and the heat dissipation panel 111 need to meet a specific limit value. This means that internal space of the photovoltaic optimizer 100 needs to be compromised to meet the foregoing requirements. This leads to an increase in costs and an amount of potting adhesive used.

Specifically, if the photovoltaic optimizer 100 is not filled with potting adhesive, a contamination level may be 2 according to a requirement of the safety regulation. In this case, an electric clearance and creepage distance limit value is greater than or equal to 20 mm. An excessively large electric clearance and creepage distance leads to an increase in an overall size of the photovoltaic optimizer 100 or a size of a component of the photovoltaic optimizer 100, an amount of potting adhesive used, and costs. If the photovoltaic optimizer 100 is filled with potting adhesive, the contamination level may decrease from 2 to 1, and the electric clearance and creepage distance limit value (8.3 mm) is reduced. The electric clearance is a shortest spatial distance measured between two conducting components or between a conducting component and a protection interface of a device, to be specific, a shortest distance at which insulation can be implemented through air when stability and safety of electrical performance are ensured. The creepage distance is a shortest path, measured along an insulated surface, between two conducting components or between a conducting component and a protection interface of a device.

Therefore, compared with the case in which the photovoltaic optimizer 100 is not filled with potting adhesive, in the case in which the photovoltaic optimizer 100 is filled with potting adhesive, an overall size of the photovoltaic optimizer 100 or a size of a component of the photovoltaic optimizer 100 can be reduced, so that an amount of potting adhesive used is reduced, and costs are also correspondingly reduced.

However, even if the photovoltaic optimizer 100 is filled with potting adhesive, the photovoltaic optimizer 100 may still be subject to the following risks: Risk 1: A discharge phenomenon occurs between the mainboard 120 and the heat dissipation panel 111. Risk 2: A discharge phenomenon occurs between the cable terminal 141 and the metal housing (for example, the heat dissipation panel 111 or the cover 130) of the photovoltaic optimizer 100.

FIG. 3 is a schematic cross-sectional view of a connection part between the mainboard 120 and the heat dissipation panel 111 in FIG. 2. It can be learned from FIG. 3 that an insulation supporting member 200 is mounted between the mainboard 120 and the heat dissipation panel 111. The insulation supporting member 200 may be configured to support the mainboard 120, and a side surface of the insulation supporting member 200 is flat. Potting adhesive 160 is applied between the mainboard 120 and the heat dissipation panel 111. The potting adhesive 160 is used for insulation and heat dissipation. Therefore, a creepage path between an energized network 170 and the heat dissipation panel 111 may be a creepage path 180 shown in FIG. 3.

For example, if a vertical distance between the mainboard 120 and the heat dissipation panel 111 is 4.4 mm, the creepage distance between the energized network 170 and the heat dissipation panel 111 is 4.4 mm. The vertical distance is a distance between the mainboard 120 and the heat dissipation panel 111 along a first direction. The first direction is perpendicular to a plane on which the mainboard 120 is located. To be specific, the creepage distance is less than the creepage distance limit value of 8.3 mm. If the creepage distance limit of 8.3 mm needs to be met, a vertical distance between the energized network 170 and the heat dissipation panel 111 needs to reach 8.3 mm, or an avoidance distance of 4 mm needs to be added on the mainboard 120.

Therefore, to avoid the risk 1, to be specific, to avoid a discharge phenomenon between the mainboard 120 and the heat dissipation panel 111, a distance between the mainboard 120 and the heat dissipation panel 111 needs to be increased, or a width of the mainboard 120 needs to be increased. Further, an overall thickness of the photovoltaic optimizer 100 increases, or a width of the photovoltaic optimizer 100 increases. Consequently, an amount of potting adhesive used increases, and costs also correspondingly increase.

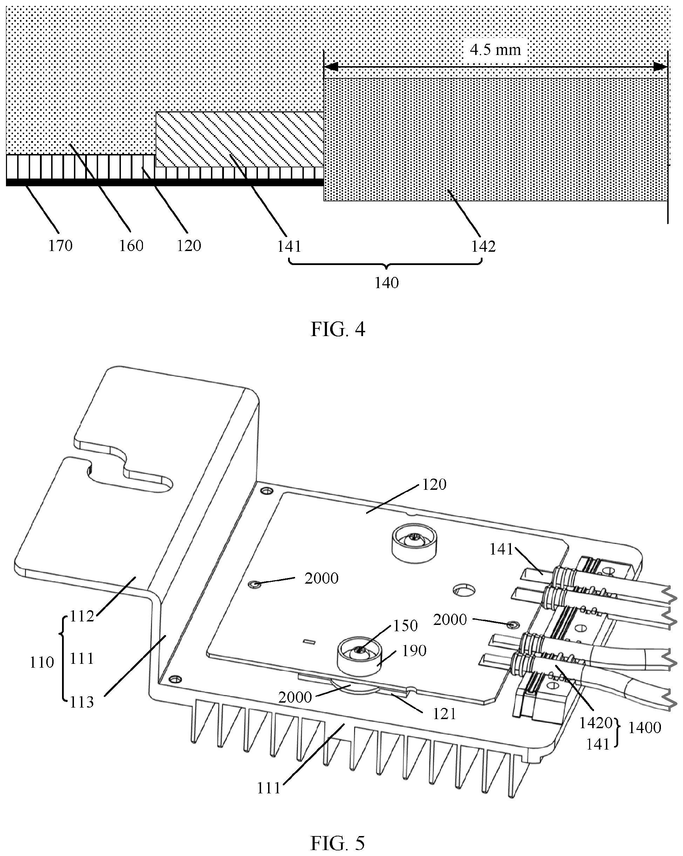

FIG. 4 is a schematic cross-sectional view of a connection part between the cable 140 and the mainboard 120 in FIG. 2. As shown in FIG. 4, the cable 140 may include a cable terminal 141 and a cable insulation sheath 142. The cable terminal 141 may be connected to the mainboard 120. The cable insulation sheath 142 may pass through a through hole on an overall housing of the photovoltaic optimizer and extend out of the accommodation cavity formed by the cover 130 and the housing 110. The accommodation cavity may be filled with insulation potting adhesive 160. A side surface of the cable insulation sheath 142 is flat. It should be understood that a discharge phenomenon may occur between the cable terminal 141 and the metal housing (for example, the heat dissipation panel 111 or the cover 130) of the photovoltaic optimizer.

For example, if a distance between an end, close to the cable insulation sheath 142, of the cable terminal 141 and the metal housing (for example, the heat dissipation panel 111) of the photovoltaic optimizer 100 is 4.5 mm, the creepage path between the energized network 170 on the mainboard 120 and the heat dissipation panel 111 is 4.5 mm. To be specific, the creepage distance is less than the creepage distance limit value of 8.3 mm. If the creepage distance limit of 8.3 mm needs to be met, a horizontal distance between the energized network 170 on the mainboard 120 and the heat dissipation panel 111 needs to reach 8.3 mm.

Therefore, to avoid the risk 2, to be specific, to avoid a discharge phenomenon between the cable terminal 141 and the metal housing (for example, the heat dissipation panel 111) of the photovoltaic optimizer 100, a size of the mainboard 120 needs to be increased, so that the distance between the energized network 170 on the mainboard 120 and the heat dissipation panel 111 meets the creepage distance limit value. To be specific, an overall length of the photovoltaic optimizer needs to be increased. Consequently, an amount of potting adhesive used increases, and costs also correspondingly increase.

In view of the foregoing risks, in embodiments of this application, safety design is performed on components, such as the insulation supporting member 200 and the cable insulation sheath 142, in the creepage path. In this way, when the electric clearance and creepage distance limit is met, an overall size of the photovoltaic optimizer or a size of a component of the photovoltaic optimizer is reduced, to reduce an amount of potting adhesive used, and reduce costs.

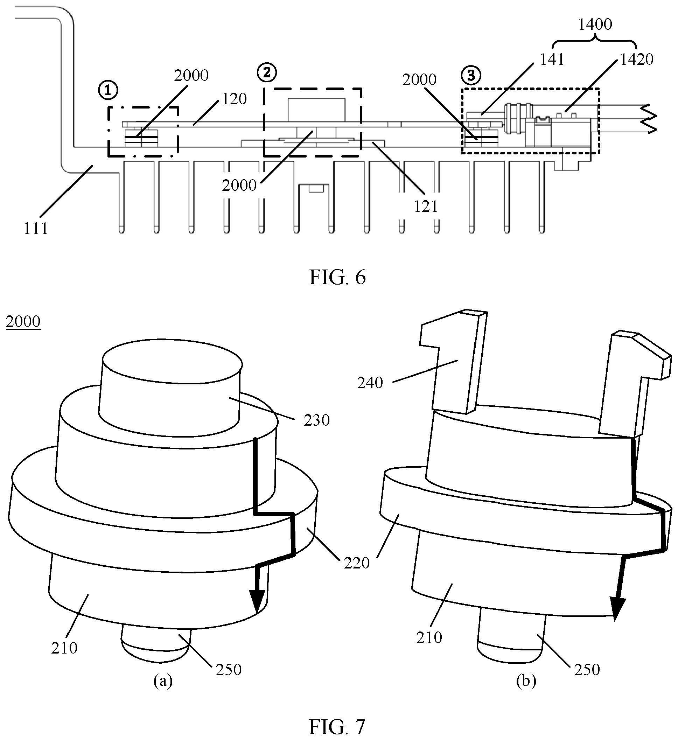

FIG. 5 is a diagram of a partial structure of a photovoltaic optimizer according to an embodiment of this application. FIG. 6 is a side view of a structure of a photovoltaic optimizer according to an embodiment of this application.

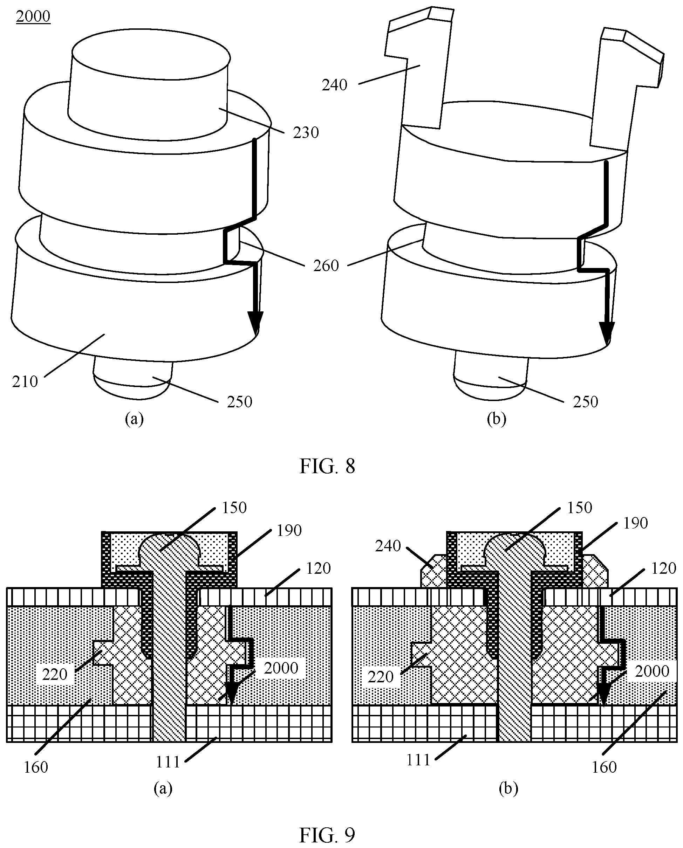

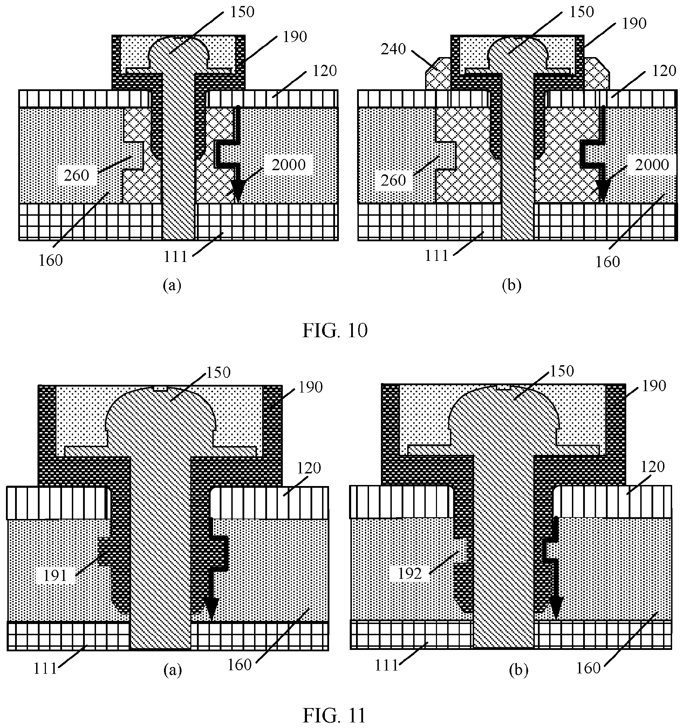

With reference to FIG. 5 and FIG. 6, it can be learned that, in view of the risk 1, to be specific, to avoid a discharge phenomenon between the mainboard 120 and the heat dissipation panel 111, embodiments of this application provide an insulation supporting member 2000 shown in a region ① in FIG. 6 or an insulation supporting member 2000 shown in a region ② in FIG. 6. A structure of the insulation supporting member 2000 shown in the region ① is specifically described with reference to FIG. 7 and FIG. 8. The insulation supporting member 2000 shown in the region ② is specifically described with reference to FIG. 9 and FIG. 10. For a specific position for disposing the insulation supporting member 2000, refer to FIG. 5.

In addition, in view of the risk 1, embodiments of this application further provide an insulation screw sleeve 190 shown in FIG. 11.

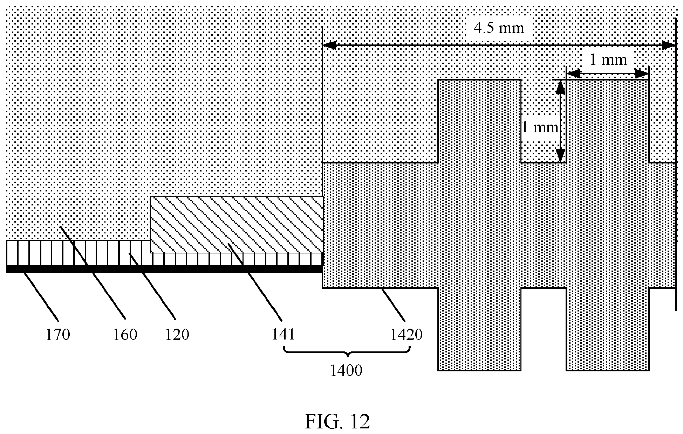

In view of the risk 2, to be specific, to avoid a discharge phenomenon between the cable terminal 141 and the metal housing (for example, the heat dissipation panel 111) of the photovoltaic optimizer, embodiments of this application provide a cable insulation sheath 1420 shown in a region ③ in FIG. 6. A structure of the cable insulation sheath 1420 is specifically described with reference to FIG. 12.

In a possible implementation, the photovoltaic optimizer provided in this application includes a cover 130, a heat dissipation panel 111, a mainboard 120, and an insulation supporting member 2000. The cover 130 is fastened to the heat dissipation panel 111, and an accommodation cavity is formed between the cover 130 and the heat dissipation panel 111. The mainboard 120 is located in the accommodation cavity. The insulation supporting member 2000 is mounted between the mainboard 120 and the heat dissipation panel 111. The insulation supporting member 2000 is configured to support the mainboard 120. At least one ring-shaped boss or at least one ring-shaped groove is provided on a side surface of the insulation supporting member 2000 along a first direction. The first direction is perpendicular to a plane on which the mainboard 120 is located.

In an example, as shown in FIG. 5 and FIG. 6, the photovoltaic optimizer provided in this application may further include an aluminum substrate 121. The aluminum substrate 121 is located between the mainboard 120 and the heat dissipation panel 111 and is fastened to the mainboard 120. A power device is mounted on the aluminum substrate 121. In this example, the aluminum substrate 121 is disposed between the mainboard 120 and the heat dissipation panel 111, and a power device (for example, a MOS transistor or a diode) that generates a large amount of heat may be mounted on the aluminum substrate 121. This can reduce a quantity of power devices on the mainboard 120, and can also increase a heat transfer path for the power device, to accelerate heat dissipation.

In some embodiments, for a structure of the insulation supporting member 2000, refer to FIG. 7. The insulation supporting member 2000 may be an insulation supporting post, and the insulation supporting post may be a solid insulation supporting post with a boss structure.

Specifically, as shown in FIG. 7, at least one ring-shaped boss 220 is provided on a side surface of the insulation supporting member 2000 along the first direction, and the first direction is perpendicular to the plane on which the mainboard 120 is located. It can be understood that a projection of a body part of the insulation supporting member 2000 on the mainboard 120 falls within a range of a projection of the ring-shaped boss 220 of the insulation supporting member 2000 on the mainboard 120. To be specific, the insulation supporting member 2000 may include the body part and a convex part that protrudes outward along a side surface of the body part, and the projection of the body part on the mainboard 120 falls within a range of a projection of the convex part on the mainboard 120.

For example, as shown in FIG. 7, the insulation supporting member 2000 includes a body part 210 and the ring-shaped boss 220. The body part 210 may be a cylinder, the ring-shaped boss 220 may be sleeved on the body part 210, and an inner side wall of the ring-shaped boss 220 may be connected to an outer side wall of the body part 210. On the whole, the insulation supporting member 2000 includes the body part 210 and a convex part that protrudes outward along a side wall of the body part 210, and the convex part that protrudes outward forms the ring-shaped boss 220. To be specific, the insulation supporting member 2000 includes the body part 210 and the convex part that protrudes outward along the side wall of the body part 210, and a projection of the body part 210 along the first direction falls within a range of a projection of the convex part along the first direction.

With the ring-shaped boss 220 provided, a creepage distance between the mainboard 120 and the heat dissipation panel 111 can be increased, where the creepage distance is indicated by a black arrow in FIG. 7. This can avoid a risk of a discharge phenomenon between the mainboard 120 and the heat dissipation panel 111. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

It should be understood that a larger quantity of ring-shaped bosses 220 sleeved on the body part 210 indicates a larger creepage distance between the mainboard 120 and the heat dissipation panel 111, and a smaller distance (namely, a vertical distance) between the mainboard 120 and the heat dissipation panel 111 along the first direction. In this way, an overall thickness of the photovoltaic optimizer can be smaller, an amount of potting adhesive used decreases, and costs also correspondingly decrease.

In some other embodiments, for the insulation supporting member 2000, refer to FIG. 8. The insulation supporting member 2000 may be an insulation supporting post, and the insulation supporting post may be a solid insulation supporting post with a groove structure.

Specifically, as shown in FIG. 8, at least one ring-shaped groove 260 is provided on the insulation supporting member 2000 along the first direction, and the first direction is perpendicular to the plane on which the mainboard 120 is located. It can be understood that a projection of the ring-shaped groove 260 of the insulation supporting member 2000 on the mainboard 120 falls within a range of a projection of a body part of the insulation supporting member 2000 on the mainboard 120. To be specific, the insulation supporting member 2000 may include the body part and a recessed part that is recessed inward along a side surface of the body part, and a projection of the recessed part on the mainboard 120 falls within the range of the projection of the body part on the mainboard 120.

For example, as shown in FIG. 8, the insulation supporting member 2000 includes a body part 210 and the ring-shaped groove 260. The body part 210 may be in a cylindrical structure, and the ring-shaped groove 220 that is recessed inward is provided on the body part 210. To be specific, the insulation supporting member 2000 includes the body part 210 and a recessed part that is recessed inward along a side wall of the body part 210, and a projection of the recessed part along the first direction falls within a range of a projection of the body part 210 along the first direction.

With the ring-shaped groove 260 provided, a creepage distance between the mainboard 120 and the heat dissipation panel 111 can be increased, where the creepage distance is indicated by a black arrow in FIG. 8. This can avoid a risk of a discharge phenomenon between the mainboard 120 and the heat dissipation panel 111. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

It should be understood that, when the at least one ring-shaped groove 220 is provided on the insulation supporting member 2000 along the first direction, a distance of the ring-shaped groove 220 along the first direction is greater than a specific limit value, so that potting adhesive can flow into the ring-shaped groove 220 on the insulation supporting member 2000.

It should be further understood that a larger quantity of ring-shaped grooves 220 on the body part 210 indicates a larger creepage distance between the mainboard 120 and the heat dissipation panel 111, and a smaller distance (namely, a vertical distance) between the mainboard 120 and the heat dissipation panel 111 along the first direction. In this way, an overall thickness of the photovoltaic optimizer can be smaller, an amount of potting adhesive used decreases, and costs also correspondingly decrease.

In an example, as shown in (a) in FIG. 7 or (a) in FIG. 8, the insulation supporting member 2000 further includes a clamping post 230, and the clamping post 230 is connected to an end face, close to the mainboard 120, of the body part 210. The clamping post 230 is configured to clamp the mainboard 120 and the insulation supporting member 2000. A projection of the clamping post 230 on a first plane falls within a range of a projection of the body part 210 on the first plane, and the first plane is the plane on which the mainboard 120 is located. For example, a clamping post hole may be provided at a position, on the mainboard 120, that corresponds to the clamping post 230, and the clamping post 230 can pass through the clamping post hole and be clamped on the mainboard 120, so that the insulation supporting member 2000 is fastened to the mainboard 120 to clamp the mainboard 120.

In another example, as shown in (b) in FIG. 7 or (b) in FIG. 8, the insulation supporting member 2000 further includes at least one fastener (for example, a fastener 240), and the fastener 240 is connected to an end face, close to the mainboard 120, of the body part 210. The fastener 240 is configured to clamp the mainboard 120 and the insulation supporting member 2000. To be specific, the insulation supporting member 2000 may be fastened to the mainboard 120 through the fastener 240. For example, a fastener hole may be provided at a position, on the mainboard 120, that corresponds to the fastener 240. A position of the fastener hole is in a one-to-one correspondence with a position of the fastener. The fastener 240 may pass through the fastener hole to fasten the insulation supporting member 2000 and the mainboard 120. To be specific, the insulation supporting member 2000 may be fastened to the mainboard 120 through the fastener 240, to clamp the mainboard 120.

In still another example, adhesive may be applied to an end face, close to the mainboard 120, of the insulation supporting member 2000. To be specific, the insulation supporting member 2000 may be bonded to the mainboard 120, to fasten the insulation supporting member 2000 to the mainboard 120 and clamp the mainboard 120.

In an example, as shown in FIG. 7 or FIG. 8, the insulation supporting member 2000 further includes a positioning post 250. The positioning post 250 is connected to an end face, close to the heat dissipation panel 111, of the body part 210. The positioning post 250 may be used for coarse positioning during assembly of the entire system.

It should be noted that a position for disposing the insulation supporting member 2000 shown in FIG. 7 or FIG. 8 is not limited in this application, and may be determined based on an actual layout of power devices on the mainboard 120 and the aluminum substrate 121. In some examples, the insulation supporting member 2000 may be disposed at a midpoint position on each of four sides of the mainboard 120. For example, as shown in FIG. 5 and FIG. 6, the insulation supporting member 2000 may be disposed at a midpoint position on a side, close to a connecting plate 113, of the heat dissipation panel 111; or the insulation supporting member 2000 may be disposed at a midpoint position on a side, close to a cable 1400, of the heat dissipation panel 111.

It should be noted that, if the vertical distance between the mainboard 120 and the heat dissipation panel 111 is small but a length or a width of the mainboard 120 is large, a quantity and sizes of ring-shaped bosses 220 or ring-shaped grooves 260 may be reduced by setting an avoidance distance on the mainboard 120. If the vertical distance between the mainboard 120 and the heat dissipation panel 111 is large, a quantity of ring-shaped bosses 220 or ring-shaped grooves 260 may be increased, or a size of the ring-shaped boss 220 or the ring-shaped groove 260 may be increased, to reduce an avoidance distance that is set on the mainboard 120, and reduce a size of the mainboard 120.

In some other embodiments, for a structure of the insulation supporting member 2000, refer to FIG. 9. FIG. 9 shows two schematic cross-sectional views of the insulation supporting member 2000. The cross section is perpendicular to the plane on which the mainboard 120 is located. The insulation supporting member 2000 may be a hollow insulation supporting member with a boss structure.

Specifically, as shown in FIG. 9, at least one ring-shaped boss 220 is provided on a side surface of the insulation supporting member 2000 along the first direction, and the first direction is perpendicular to the plane on which the mainboard 120 is located. The insulation supporting member 2000 may be in a hollow structure, and a screw 150 may pass through the insulation supporting member 2000 to fasten the mainboard 120 and the heat dissipation panel 111 together.

In an example, the insulation supporting member 2000 includes a body part and the ring-shaped boss 220. The body part may be in a hollow cylindrical structure, the ring-shaped boss 220 may be sleeved on the body part, and the insulation supporting member 2000 in a hollow structure may be used together with the screw 150.

With the ring-shaped boss 220 provided, a creepage distance between the mainboard 120 and the heat dissipation panel 111 can be increased, where the creepage distance is indicated by a black arrow in FIG. 9. This can avoid a risk of a discharge phenomenon between the mainboard 120 and the heat dissipation panel 111. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

It should be understood that a larger quantity of ring-shaped bosses 220 sleeved on the body part of the insulation supporting member 2000 indicates a larger creepage distance between the mainboard 120 and the heat dissipation panel 111, and a smaller distance (namely, a vertical distance) between the mainboard 120 and the heat dissipation panel 111 along the first direction. In this way, an overall thickness of the photovoltaic optimizer can be smaller, an amount of potting adhesive used decreases, and costs also correspondingly decrease.

In some other embodiments, for a structure of the insulation supporting member 2000, refer to FIG. 10. FIG. 10 shows two schematic cross-sectional views of the insulation supporting member 2000. The cross section is perpendicular to the plane on which the mainboard 120 is located. The insulation supporting member 2000 may be a hollow insulation supporting member with a groove structure.

Specifically, as shown in FIG. 10, at least one ring-shaped groove 260 is provided on a side surface of the insulation supporting member 2000 along the first direction, and the first direction is perpendicular to the plane on which the mainboard 120 is located. The insulation supporting member 2000 may be in a hollow structure, and a screw 150 may pass through the insulation supporting member 2000 to fasten the mainboard 120 and the heat dissipation panel 111 together.

In an example, the insulation supporting member 2000 includes a body part and the ring-shaped groove 260. The body part may be in a hollow cylindrical structure, the ring-shaped groove 260 that is recessed inward is provided on the body part, and the insulation supporting member 2000 in a hollow structure may be used together with the screw 150.

With the ring-shaped groove 260 provided, a creepage distance between the mainboard 120 and the heat dissipation panel 111 can be increased, where the creepage distance is indicated by a black arrow in FIG. 10. This can avoid a risk of a discharge phenomenon between the mainboard 120 and the heat dissipation panel 111. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

It should be understood that a larger quantity of ring-shaped grooves 260 indicates a larger creepage distance between the mainboard 120 and the heat dissipation panel 111, and a smaller distance (namely, a vertical distance) between the mainboard 120 and the heat dissipation panel 111 along the first direction. In this way, an overall thickness of the photovoltaic optimizer can be smaller, an amount of potting adhesive used decreases, and costs also correspondingly decrease.

As shown in FIG. 9 or FIG. 10, a first through hole is provided on the mainboard 120, a second through hole is provided on the insulation supporting member 2000 along the first direction, a threaded hole corresponding to the screw 150 is provided on the heat dissipation panel 111, the threaded hole, the first through hole, and the second through hole overlap on a projection plane along the first direction, and the screw 150 passes through the first through hole and the second through hole and is fastened to the threaded hole on the heat dissipation panel 111.

In an example, an insulation material is applied between the screw 150 and the mainboard 120 to isolate the mainboard 120 from the screw 150.

In another example, as shown in FIG. 9 or FIG. 10, an insulation screw sleeve 190 may be sleeved on an outer surface of the screw 150. To be specific, the screw sleeve is made of an insulation material, and the insulation screw sleeve 190 may isolate the mainboard 120 from the screw 150. For example, the screw 150 includes a screw head and a screw rod, a part of the insulation screw sleeve 190 is located between the mainboard 120 and the screw head, a part of the insulation screw sleeve 190 passes through the first through hole and extends into the second through hole, and the screw rod passes through a part, passing through the second through hole, of the insulation screw sleeve 190, and is fastened to the threaded hole. To be specific, the insulation screw sleeve 190 is provided between the screw 150 and the mainboard 120 to isolate the screw 150 from the mainboard 120, and the insulation screw sleeve 190 (for example, a screw sleeve made of a plastic material) can perform a function of isolating the screw 150 from the mainboard 120. It should be understood that a projection of the screw head on the plane on which the mainboard 120 is located can cover the first through hole on the mainboard 120.

In an example, as shown in (a) in FIG. 9 or (a) in FIG. 10, adhesive may be applied to an end face, close to the mainboard 120, of the insulation supporting member 2000, and an end, away from the mainboard 120, of the insulation supporting member 2000 may abut against the heat dissipation panel 111. To be specific, the insulation supporting member 2000 may be bonded to the mainboard 120, to fasten the insulation supporting member 2000 to the mainboard 120.

In another example, as shown in (b) in FIG. 9 or (b) in FIG. 10, the insulation supporting member 2000 further includes at least one fastener 240, and the fastener 240 is connected to an end face, close to the mainboard 120, of the body part. The fastener 240 is configured to clamp the mainboard 120 and the insulation supporting member 2000. To be specific, the insulation supporting member 2000 may be fastened to the mainboard 120 through the fastener 240. For example, a fastener hole may be provided at a position, on the mainboard 120, that corresponds to the fastener 240. A position of the fastener hole is in a one-to-one correspondence with a position of the fastener. The fastener 240 may pass through the fastener hole to fasten the insulation supporting member 2000 and the mainboard 120. To be specific, the insulation supporting member 2000 may be fastened to the mainboard 120 through the fastener 240.

It should be noted that, regardless of whether fastening is performed through bonding or by using the fastener, projections of the first through hole on the mainboard 120, the second through hole on the insulation supporting member 2000, and the threaded hole on the heat dissipation panel 111 along the first direction overlap. In this way, the screw 150 can pass through the first through hole and the second through hole and be mounted in the threaded hole, to fasten the mainboard 120 to the heat dissipation panel 111.

It should be noted that a position for disposing the insulation supporting member 2000 shown in FIG. 9 or FIG. 10 is not limited in this application, and may be determined based on an actual layout of power devices on the mainboard 120 and the aluminum substrate 121. In some examples, the insulation supporting member 2000 may be disposed at a midpoint position on each of four sides of the mainboard 120. In some other examples, as shown in FIG. 5 and FIG. 6, the insulation supporting member 2000 may be located between the mainboard 120 and the aluminum substrate 121, and the screw 150 can pass through the insulation supporting member 2000 and the heat dissipation panel 111 and be fastened to the heat dissipation panel 111.

In another possible implementation, the photovoltaic optimizer provided in this application includes a cover 130, a heat dissipation panel 111, a mainboard 120, a screw 150, and an insulation screw sleeve 190. The cover 130 is fastened to the heat dissipation panel 111, and an accommodation cavity is formed between the cover 130 and the heat dissipation panel 111. The mainboard 120 is located in the accommodation cavity. A first through hole is provided on the mainboard 120. A threaded hole corresponding to the screw 150 is provided on the heat dissipation panel 111. The threaded hole and the first through hole overlap on a projection plane along a first direction. The first direction is perpendicular to a plane on which the mainboard 120 is located. The screw 150 includes a screw head and a screw rod. A part of the insulation screw sleeve 190 is located between the mainboard 120 and the screw head. A part of the insulation screw sleeve 190 passes through the first through hole and extends toward the heat dissipation panel 111. The screw rod passes through a part, passing through the second through hole, of the insulation screw sleeve 190, and is fastened to the threaded hole. At least one ring-shaped boss or at least one ring-shaped groove is provided, along the first direction, on a part, passing through the first through hole, of the insulation screw sleeve 190.

For example, a cross-sectional structure of the insulation screw sleeve 190 may be shown in FIG. 11.

As shown in (a) in FIG. 11, at least one ring-shaped boss 191 is provided, along the first direction, on a part, passing through the first through hole on the mainboard 120, of the insulation screw sleeve 190. With the ring-shaped boss 191 provided, a creepage distance between the mainboard 120 and the heat dissipation panel 111 can be increased. The creepage distance is indicated by a black arrow in (a) in FIG. 11.

As shown in (b) in FIG. 11, at least one ring-shaped groove 192 is provided, along the first direction, on a part, passing through the first through hole on the mainboard 120, of the insulation screw sleeve 190. With the ring-shaped groove 192 provided, a creepage distance between the mainboard 120 and the heat dissipation panel 111 can be increased. The creepage distance is indicated by a black arrow in (b) in FIG. 11.

It should be understood that a larger quantity of ring-shaped bosses 191 or ring-shaped grooves 192 indicates a larger creepage distance between the mainboard 120 and the heat dissipation panel 111, and a smaller distance (namely, a vertical distance) between the mainboard 120 and the heat dissipation panel 111 along the first direction. In this way, an overall thickness of the photovoltaic optimizer can be smaller, an amount of potting adhesive used decreases, and costs also correspondingly decrease.

It should be understood that, when the at least one ring-shaped groove 191 is provided on the insulation screw sleeve 190 along the first direction, a distance of the ring-shaped groove 191 along the first direction is greater than a specific limit value, so that potting adhesive can flow into the groove on the insulation screw sleeve 190.

It should be noted that the insulation screw sleeve 190 shown in FIG. 11 may be used together with the screw 150. The insulation screw sleeve 190 with the ring-shaped boss 191 or the ring-shaped groove 192 is provided, so that a distance between a bottom wiring layer of the mainboard 120 and the heat dissipation panel 111 can be shortened, to reduce an overall thickness of the photovoltaic optimizer, reduce an amount of potting adhesive used, and reduce costs.

To be specific, in the photovoltaic optimizer provided in this application, the at least one ring-shaped boss 191 or the at least one ring-shaped groove 192 may be further provided on the insulation screw sleeve 190 in a creepage path, to increase a creepage distance, and avoid a risk of a discharge phenomenon between the mainboard 120 and the heat dissipation panel 111. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

With reference to FIG. 5 to FIG. 11, it can be learned that, in embodiments of this application, for the risk 1, the insulation supporting member 2000 with a boss or groove design may be used, or the insulation screw sleeve 190 with a boss or groove design may be used, to shorten a distance between the bottom wiring layer of the mainboard 120 and the heat dissipation panel 111, reduce an overall thickness of the optimizer, and therefore reduce an amount of potting adhesive used and reduce costs.

With reference to FIG. 12, the following describes an improvement made for the risk 2 in embodiments of this application. FIG. 12 is a schematic cross-sectional view of a connection between a cable 1400 and a mainboard 120 according to an embodiment of this application.

As shown in FIG. 12, the cable 1400 includes a cable terminal 141 and a cable insulation sheath 1420. The cable 1400 may be connected to the mainboard 120 through the cable terminal 141. At least one ring-shaped boss is provided on the cable insulation sheath 1420 along a second direction, the at least one ring-shaped boss on the cable insulation sheath 1400 is located in an accommodation cavity formed between a cover and a heat dissipation panel 111, and the second direction points to an extension direction of the cable 1400.

The ring-shaped boss is provided on an outer surface of the cable insulation sheath 1420 in a creepage path, to increase a creepage distance, and avoid a risk of discharging between the cable terminal 141 and a metal housing (for example, the heat dissipation panel 111) of a photovoltaic optimizer. In this way, when a creepage distance limit value is met, an overall size of the photovoltaic optimizer or a size of a component of the photovoltaic optimizer is reduced, to reduce an amount of potting adhesive used in the photovoltaic optimizer, and reduce costs.

In some embodiments, to ensure that the potting adhesive can flow well in narrow space, one ring-shaped boss is provided on the cable insulation sheath 1420 along the second direction, and a height and a thickness of the ring-shaped boss may be 1 mm. In this case, an avoidance distance of 2 mm should be reserved at a board edge of the mainboard 120. The height of the ring-shaped boss is a size along a first direction, and the thickness of the ring-shaped boss is a size along the second direction. The first direction is perpendicular to a plane on which the mainboard 120 is located, and the second direction points to the extension direction of the cable 1400.

In some other embodiments, as shown in FIG. 12, two ring-shaped bosses may be provided on the cable insulation sheath 1420, and a height and a thickness of each ring-shaped boss are 1 mm. In this way, a creepage distance of 8.5 mm can be achieved without reserving an avoidance distance of 2 mm for wiring at a board edge of the mainboard 120. This can further reduce a size of the mainboard 120.

For example, as shown in FIG. 12, if a distance between an end, close to the cable insulation sheath 1420, of the cable terminal 141 and the metal housing (for example, the heat dissipation panel 111) of the photovoltaic optimizer is 4.5 mm, a creepage distance (denoted as dₛᵤₘ) between an energized network 170 on the mainboard 120 and the heat dissipation panel 111 is 8.5 mm. The creepage distance of 8.5 mm is greater than the creepage distance limit value of 8.3 mm: dₛᵤₘ = 2 mm + 4.5 mm + 2 mm = 8.5 mm > 8.3 mm. Therefore, with the ring-shaped boss provided on the cable insulation sheath 1420, when an electric clearance and creepage distance limit is met, a vertical distance between the mainboard 120 and the heat dissipation panel 111 can be reduced, to reduce an overall thickness of the entire photovoltaic optimizer, reduce an amount of potting adhesive used, and reduce costs.

In still some other embodiments, the thickness of the ring-shaped boss on the cable insulation sheath 1420 may alternatively be set to 2 mm. In this way, an avoidance distance of 2 mm may not be reserved for wiring at a board edge of a PCB either. This can further reduce a length of the mainboard 120, to reduce an overall size of the photovoltaic optimizer, reduce an amount of potting adhesive used, and reduce costs.

It should be understood that a quantity and sizes of ring-shaped bosses on the cable insulation sheath 1420 may be specifically set based on an actual layout. This is not limited in this application.

It should be noted that the insulation supporting member 2000, the insulation screw sleeve 190, and the cable insulation sheath 1420 provided in embodiments of this application may be used in a power supply product with a requirement for a safety shielding scenario, for example, a photovoltaic optimizer, a photovoltaic inverter, or another power supply product.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic optimizer, comprising a cover, a heat dissipation panel, a mainboard, and an insulation supporting member, wherein
the cover is fastened to the heat dissipation panel, and an accommodation cavity is formed between the cover and the heat dissipation panel; and
the mainboard is located in the accommodation cavity, the insulation supporting member is mounted between the mainboard and the heat dissipation panel, the insulation supporting member is configured to support the mainboard, at least one ring-shaped boss or at least one ring-shaped groove is provided on a side surface of the insulation supporting member along a first direction, and the first direction is perpendicular to a plane on which the mainboard is located.

2. The photovoltaic optimizer according to claim 1, wherein the photovoltaic optimizer further comprises a cable, the cable comprises a cable terminal and a cable insulation sheath, the cable terminal is connected to the mainboard, at least one ring-shaped boss is provided on the cable insulation sheath along a second direction, the at least one ring-shaped boss on the cable insulation sheath is located in the accommodation cavity, and the second direction points to an extension direction of the cable.

3. The photovoltaic optimizer according to claim 1, wherein the photovoltaic optimizer further comprises a screw, a first through hole is provided on the mainboard, a second through hole is provided on the insulation supporting member along the first direction, a threaded hole corresponding to the screw is provided on the heat dissipation panel, the threaded hole, the first through hole, and the second through hole overlap on a projection plane along the first direction, and the screw passes through the first through hole and the second through hole and is fastened to the threaded hole.

4. The photovoltaic optimizer according to claim 3, wherein the photovoltaic optimizer further comprises an insulation screw sleeve, and the screw comprises a screw head and a screw rod; and
a part of the insulation screw sleeve is located between the mainboard and the screw head, a part of the insulation screw sleeve passes through the first through hole and extends into the second through hole, and the screw rod passes through a part, passing through the second through hole, of the insulation screw sleeve, and is fastened to the threaded hole.

5. The photovoltaic optimizer according to any one of claims 1 to 4, wherein at least one fastener is provided at an end, close to the mainboard, of the insulation supporting member, a fastener hole is provided at a position, on the mainboard, that corresponds to the fastener, and the fastener passes through the fastener hole to fasten the insulation supporting member and the mainboard.

6. The photovoltaic optimizer according to claim 1 or 2, wherein the insulation supporting member is an insulation supporting post; and
the insulation supporting post comprises a body part and a convex part that protrudes outward along a side wall of the body part, and a projection of the body part along the first direction falls within a range of a projection of the convex part along the first direction; or
the insulation supporting post comprises a body part and a recessed part that is recessed inward along a side wall of the body part, and a projection of the recessed part along the first direction falls within a range of a projection of the body part along the first direction.

7. The photovoltaic optimizer according to claim 6, wherein a clamping post is provided at an end, close to the mainboard, of the insulation supporting post, a projection of the clamping post along the first direction falls within the range of the projection of the body part along the first direction, a clamping post hole is provided at a position, on the mainboard, that corresponds to the clamping post, and the clamping post passes through the clamping post hole to fasten the insulation supporting post and the mainboard.

8. The photovoltaic optimizer according to any one of claims 1 to 4, wherein the insulation supporting member is at a midpoint position on each of four sides of the mainboard.

9. The photovoltaic optimizer according to any one of claims 1 to 4, wherein the photovoltaic optimizer further comprises an aluminum substrate, the aluminum substrate is located between the mainboard and the heat dissipation panel and is fastened to the mainboard, and a power device is mounted on the aluminum substrate.

10. A photovoltaic optimizer, comprising a cover, a heat dissipation panel, a mainboard, a screw, and an insulation screw sleeve, wherein
the cover is fastened to the heat dissipation panel, and an accommodation cavity is formed between the cover and the heat dissipation panel;
the mainboard is located in the accommodation cavity, a first through hole is provided on the mainboard, a threaded hole corresponding to the screw is provided on the heat dissipation panel, the threaded hole and the first through hole overlap on a projection plane along a first direction, and the first direction is perpendicular to a plane on which the mainboard is located; and
the screw comprises a screw head and a screw rod, a part of the insulation screw sleeve is located between the mainboard and the screw head, a part of the insulation screw sleeve passes through the first through hole and extends toward the heat dissipation panel, the screw rod passes through a part, passing through the second through hole, of the insulation screw sleeve, and is fastened to the threaded hole, and at least one ring-shaped boss or at least one ring-shaped groove is provided, along the first direction, on a part, passing through the first through hole, of the insulation screw sleeve.

11. The photovoltaic optimizer according to claim 10, wherein the photovoltaic optimizer further comprises a cable, the cable is located in the accommodation cavity, the cable comprises a cable terminal and a cable insulation sheath, the cable terminal is connected to the mainboard, at least one ring-shaped boss is provided on the cable insulation sheath along a second direction, the at least one ring-shaped boss on the cable insulation sheath is located in the accommodation cavity, and the second direction points to an extension direction of the cable.

12. The photovoltaic optimizer according to claim 10 or 11, wherein the photovoltaic optimizer further comprises an aluminum substrate, the aluminum substrate is located between the mainboard and the heat dissipation panel and is fastened to the mainboard, and a power device is mounted on the aluminum substrate.
